# EUROPEAN PATENT APPLICATION

(11) **EP 4 394 513 A1**
(43) Date of publication of application: **03.07.2024**
(21) Application number: 23196634.2
(22) Date of filing: 11.09.2023
(51) Int. Cl.: G03F 7/38

(54) **LIGHT RESPONSIVE PHOTORESISTS AND METHODS**

(30) Priority: 28.12.2022 US 202218147472
(71) Applicant: INTEL Corporation, Santa Clara, CA 95054 (US)
(72) Inventor: XU, Dingying, AZ, 85248 (US); RAWLINGS, Brandon, AZ, 85248 (US); ARRINGTON, Kyle, AZ, 85297 (US); SHAN, Bohan, AZ, 85226 (US); CARRAZZONE, Ryan, AZ, 85226 (US)
(74) Representative: HGF

(57) **Abstract**

Light responsive photoresists, and methods of using light responsive photoresists in processes, such as lithography processes. The light responsive photoresists may include a polymer featuring a photocleavable group. Due to the photocleavable group, the polymer may depolymerize when irradiated with one or more wavelengths of light. The depolymerized products may be in the gas phase.

## Description

### TECHNICAL FIELD

This disclosure generally relates to light responsive photoresists, more particularly, to light responsive poly(olefin sulfone) photoresists for dry development and dry stripping.

### BACKGROUND

Photoresists are used in a number of applications, and include polymer coatings, which undergo a change in solubility when exposed to one or more wavelengths of light. Due to this change in solubility, photoresists are capable of transferring a pattern to a substrate material using a light mask. Due to this feature, photoresists play an important role in lithography.

Typically, photoresists are used in processes that may include applying a photoresist to a surface during a coating process, exposing the photoresist to one or more wavelengths of light to imprint a pattern, development to remove soluble areas, plating to buildup target material in the revealed pattern, and stripping to remove the remaining photoresist.

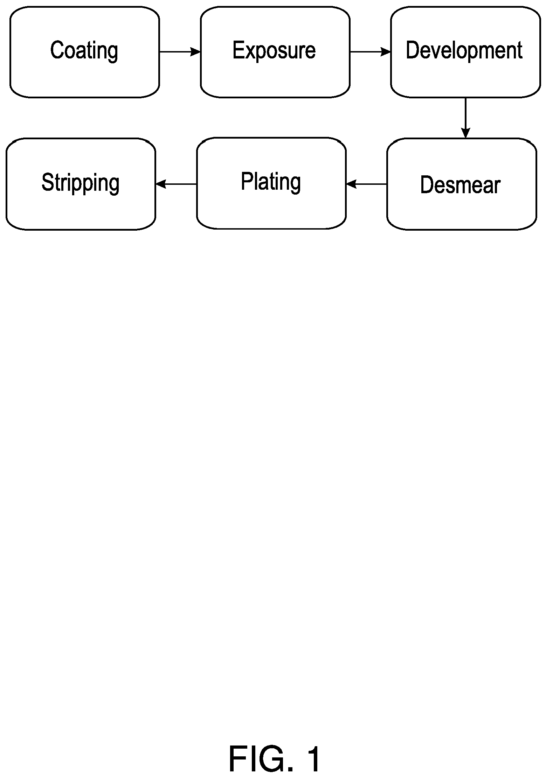

A flow chart of a typical lithography process is depicted at FIG. 1. The development and stripping phases of FIG. 1 typically require wet chemistries, which can make these phases difficult, time-consuming, harmful to the environment, or a combination thereof. For example, photoresists usually are developed after exposure using a wet chemistry process, in which a developer solution is placed on the photoresist to dissolve the areas of increased solubility. This development process also usually involves transfer of the sample from an exposure tool to a developer tool. Similarly, after plating, samples typically must be transferred to a tool equipped with stripping solutions to remove the remaining photoresist.

As the industries that use lithography seek out more "green chemistry" processes, there is an increasing need to develop solvent-less processes.

There remains a need for improved photoresists and lithography methods, which reduce or eliminate a reliance on wet chemistries, including during the development and/or stripping phases.

### BRIEF DESCRIPTION OF THE DRAWINGS

FIG. 1 depicts a flow chart of a typical lithography process.
FIG. 2 depicts a schematic of an embodiment of a light responsive photoresist, and an embodiment of a photo-triggered depolymerization sequence.
FIG. 3 depicts a flow chart of an embodiment of a lithography process that includes the use of an embodiment of a depolymerizable photoresist.

Certain implementations will now be described more fully below with reference to the accompanying drawings, in which various implementations and/or aspects are shown. However, various aspects may be implemented in many different forms and should not be construed as limited to the implementations set forth herein; rather, these implementations are provided so that this disclosure will be thorough and complete, and will fully convey the scope of the disclosure to those skilled in the art. Like numbers in the figures refer to like elements throughout. Hence, if a feature is used across several drawings, the number used to identify the feature in the drawing where the feature first appeared will be used in later drawings.

### DETAILED DESCRIPTION

The following description and the drawings sufficiently illustrate specific embodiments to enable those skilled in the art to practice them. Other embodiments may incorporate structural, logical, process, algorithm, and other changes. Portions and features of some embodiments may be included in, or substituted for, those of other embodiments. Embodiments set forth in the claims encompass all available equivalents of those claims.

Provided herein are photoresists and methods of removing photoresists, including lithography processes, which may eliminate the need for wet chemistries in the development phase, the stripping phase, or both the development phase and the stripping phase. By eliminating the use of wet chemistry in one or more phases of a lithography process, the photoresists and methods herein may establish or contribute to a green chemistry process flow. Additionally or alternatively, the photoresists and methods herein may reduce the cost of lithography processes by eliminating the need for wet chemistry enabled tools dedicated to developing and/or stripping photoresists.

In some embodiments, the methods include providing a substrate having a surface at least partially coated with a light responsive photoresist; cleaving at least a portion of the light responsive photoresist to form a cleaved photoresist; and removing the cleaved photoresist from the substrate. The cleaving and the removing of the cleaved photoresist may occur simultaneously. The substrate that is at least partially coated with a light responsive photoresist may be provided after any step of a lithography process, such as after a coating step, or after a plating step. Therefore, the cleaving of at least a portion of the light responsive photoresist may be performed as (or as part of) a development step and/or a stripping step. The cleaving may be achieved by (i) irradiating the at least a portion of the light responsive photoresist with light of one or more wavelengths effective to cleave the light responsive photoresist, (ii) heating the at least a portion of the light responsive photoresist at a temperature and for a time effective to cleave the light responsive photoresist, or (iii) a combination thereof. Due to the ability to remove the light responsive photoresist through non-specific thermal degradation with simple heating under vacuum, embodiments of the methods herein may be used to rework samples. For example, if metrology shows a poor patterning result after exposure, the sample can be heated or irradiated under vacuum to remove the light responsive photoresist gently, without undesirably impacting the sample underneath, thereby allowing a substrate, such as a panel or wafer, to be reused instead of scrapped. This possibility represents a distinct advantage over conventional photoresist materials, which require a wet chemical stripping process to clean a sample effectively.

In some embodiments, the methods include providing a substrate having a surface at least partially coated with a light responsive photoresist; cleaving a first portion of the light responsive photoresist by irradiating the first portion of the light responsive photoresist with light of one or more wavelengths effective to cleave the first portion light responsive photoresist; removing the first portion of the light responsive photoresist by vacuum; optionally subjecting the substrate to desmearing; plating the substrate with one or more materials; cleaving the second portion of the light responsive photoresist by (i) heating the second portion of the light responsive photoresist at a temperature and for a time effective to cleave the second portion of the light responsive photoresist, (ii) irradiating the second portion of the light responsive photoresist with light of one or more wavelengths effective to cleave the second portion light responsive photoresist, or (iii) a combination thereof; and removing the second portion of the light responsive photoresist.

A photoresist may be coated directly on and in contact with a surface of a substrate, on a layer pre-disposed on the substrate, or a combination thereof.

As used herein, the phrase "light responsive photoresist" refers to a photoresist having a chemical structure that can be cleaved (e.g., by breaking of a covalent bond) at one or more locations of the chemical structure upon and/or after irradiation with one or more wavelengths of electromagnetic radiation (e.g., light) and/or exposure to an increased temperature.

A light responsive photoresist, prior to cleaving, may be in a solid phase at room temperature and atmospheric pressure, or the conditions under which a lithography process is performed. In some embodiments, a light responsive photoresist, after cleaving, is in a gas phase at room temperature and atmospheric pressure, or the conditions under which a lithography process is performed.

One or more specific wavelengths of light may cleave a light responsive photoresist, due to the presence of the photocleavable groups. The photocleavable groups may be selected based on the one or more wavelengths of light a user wishes to employ during any of the methods herein. The light of one or more wavelengths may consist of light of one wavelength, such as 365 nm, or 450 nm. The light of one or more wavelengths may consist of light of two or more wavelengths within a range of about 10 nm. For example, the light of one or more wavelengths may consist of light having two or more wavelengths of from about 360 nm to about 370 nm, or from about 445 nm to about 455 nm. Additionally or alternatively, elevated temperatures may cleave a light responsive photoresist. The use of elevated temperatures, therefore, may be used to remove any residual light responsive photoresist during stripping.

As used herein, the phrase "photocleavable group" refers to a photo-labile substituent that can be removed from a compound or macromolecule, e.g., a polymer, upon irradiation with one or more wavelengths of electromagnetic radiation (e.g., light) and/or exposure to an increased temperature, wherein the removal of the photocleavable group may generate a radical (see, e.g., **Scheme 2).** Therefore, a monomer that includes a photocleavable group may be a photo-radical generator co-monomer.

A photo-radical generator co-monomer may be tuned to control or modify the wavelength sensitivity of a light responsive photoresist. For example, a photo-radical generator co-monomer may include moieties, such as trithiocarbonates, xanthates, or aryl dithioesters. These examples of photo-radical generator co-monomers can respond to different wavelengths, with aryl dithioesters being most active at about 365 nm, xanthates at about 385 nm, and trithiocarbonates at about 450 nm. Within each of these three photo-sensitive co-monomer classes, structural changes can be utilized to further tune the target wavelength or polymer properties.

The cleaving of the first portion of the light responsive photoresist and the removing of the first portion of the light responsive photoresist may occur simultaneously. The cleaving of the second portion of the light responsive photoresist and the removing of the second portion of the light responsive photoresist may occur simultaneously.

As used herein, two actions occur "simultaneously" when the two actions are concurrent at any point. For example, two actions, each lasting 10 seconds, occur "simultaneously" when the two actions begin at 0 seconds and end at 10 seconds; or when the first of the two actions begins at 0 seconds, and the second of the two actions begins less than 10 seconds later.

The removing of a light responsive photoresist after cleaving may be achieved by any known technique. In some embodiments, the removing of a light responsive photoresist includes applying vacuum, heat, or a combination thereof. The removing of a cleaved photoresist may include an active action (e.g., applying vacuum and/or heat), a passive action (e.g., removing a substrate from an enclosure, such as a vacuum oven, and permitting a cleaved photoresist in the gas phase to diffuse), or a combination thereof.

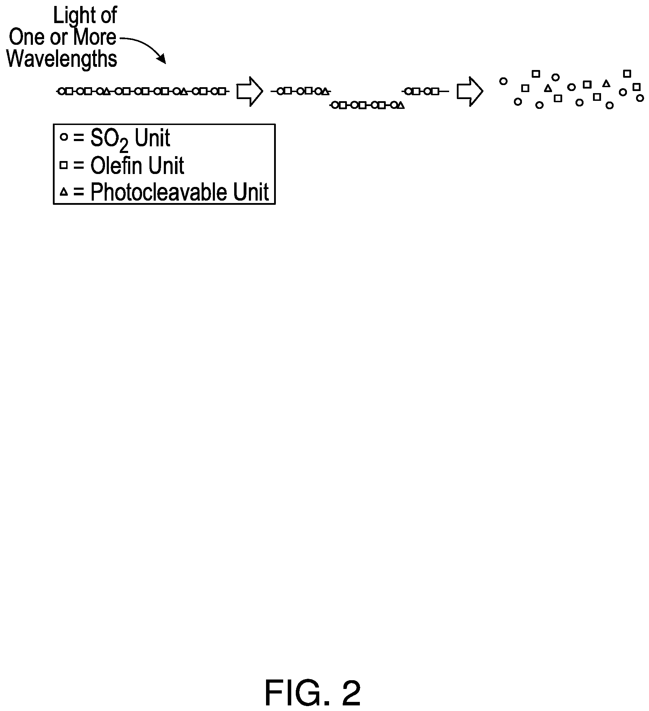

In some embodiments, a light responsive photoresist includes a polymer. The polymer may include a plurality of side chains that include a photocleavable group. In some embodiments, the light responsive photoresist includes a poly(olefin sulfone) that includes a side chain featuring a photocleavable group. The photocleavable groups may be dispersed throughout a polymer, e.g., at random intervals along the backbone of a polymer, thereby facilitating cleavage of the polymer at or near each location of an irradiated photocleavable group. Therefore, in some embodiments, the cleaving may "depolymerize" the polymer, as depicted, for example, at FIG. 2. The depolymerization may result in depolymerization products having a volatility that facilitates their removal by vacuum and/or passive diffusion, thereby eliminating the need for wet chemistries during the development or stripping phases.

As used herein, the term "polymer" refers to a compound formed by two or more monomers of the same or different type that are covalently bonded to each other; therefore, the term "polymer" refers to and includes homopolymers, copolymers, oligomers, etc. having any arrangement, e.g., straight, branched, crosslinked, star, comb, etc.

When a light responsive photoresist includes a polymer, the polymer may have any molecular weight that does not undesirably impact the process in which the light responsive photoresist is used. In some embodiments, the polymer has a weight average molecular weight (Mw) of about 50,000 g/mol to about 1,000,000 g/mol, about 100,000 g/mol to about 1,000,000 g/mol, about 100,000 g/mol to about 750,000 g/mol, or about 100,000 g/mol to about 500,000 g/mol.

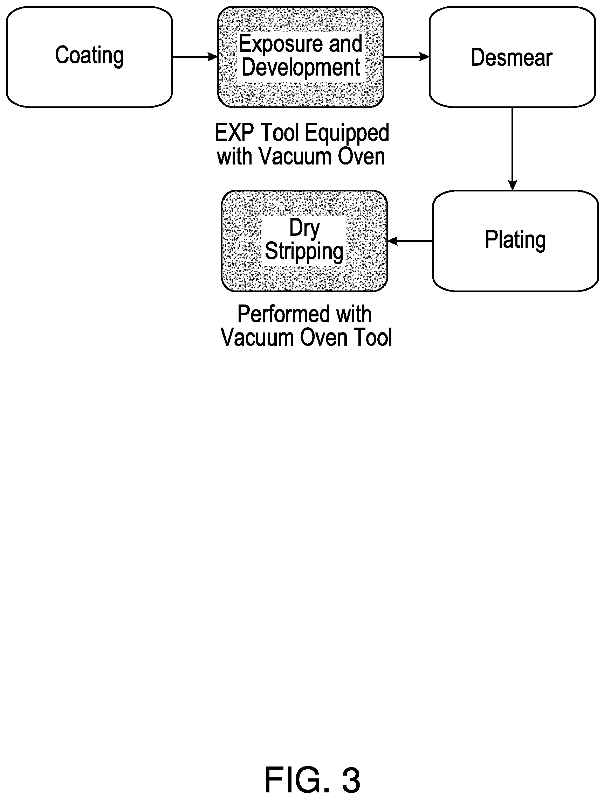

Due to the depolymerization of some embodiments of the photoresists into volatile depolymerization products, some embodiments of the photoresists herein fundamentally differ from conventional photoresists, because those herein can undergo a change in state (e.g., from a solid phase to a gas phase), instead of a change in solubility upon exposure to light or elevated temperatures. Due at least to this difference the process flow of lithography processes that use embodiments of the light responsive photoresists provided herein are not required to include wet chemistry steps during development and/or stripping, as depicted at FIG. 3. The "Exposure and Development" process of FIG. 3 may be performed, at least in part, with an exposure tool equipped with a vacuum oven. The vacuum oven may facilitate, or assist, the removal of the cleaved photoresist. Similarly, the "Dry Stripping" process of FIG. 3 may be performed with a vacuum oven tool, which, again, may facilitate, or assist, the removal of the cleaved photoresist.

When the light responsive photoresist includes a poly(olefin sulfones), the poly(olefin sulfone) may be produced from the alternating radical polymerization of SO₂ units, an alkene, and a third comonomer that includes a photocleavable group. In some embodiments, the third comonomer is an olefin-functionalized photo-radical generator, as depicted in the following scheme.

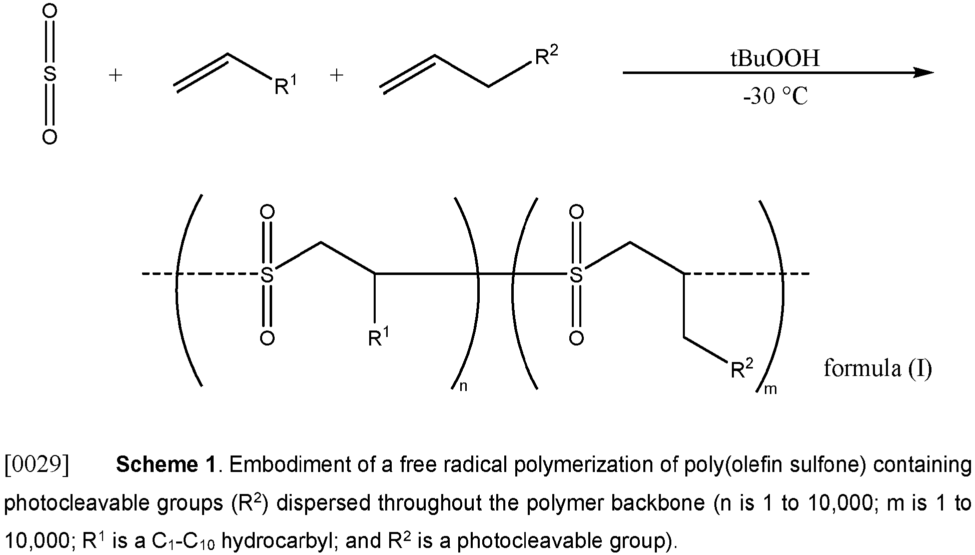

During the polymerization depicted at **Scheme 1**, the photo-labile groups (R²) may be randomly distributed throughout the polymer backbone. Subsequent irradiation with one or more wavelengths of light specific to the photo-radical generator (R²) may trigger depolymerization of the polymer, which may occur according the mechanism depicted at the following scheme. The following scheme depicts a polymer of formula (Ia) (see below), but other polymers of formula (I) may proceed according to the depicted mechanism:

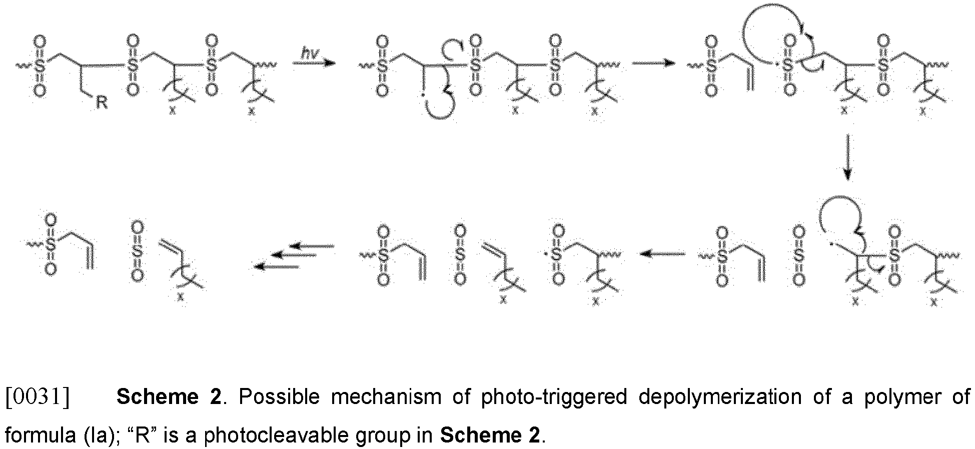

In some embodiments, the light responsive photoresist includes a polymer of formula (I): 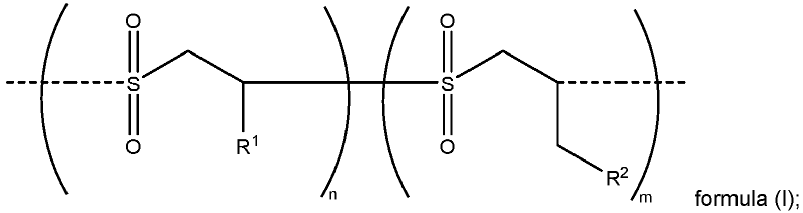 wherein n is 1 to 10,000; wherein m is 1 to 10,000; wherein R¹ is a C₁-C₁₀ hydrocarbyl; and wherein
R² is a photocleavable group. R¹ may not include an electron withdrawing group.
In some embodiments, R² is a photocleavable group of formula (II) - 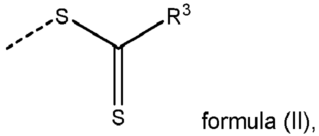 wherein R³ is selected from the group consisting of - 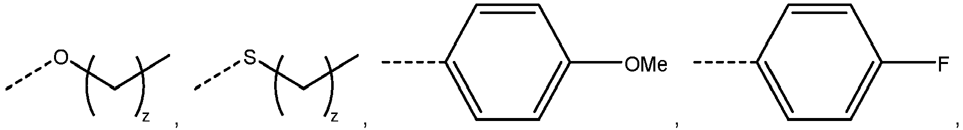 and 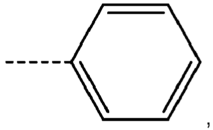 wherein z is 1 to 11. In some embodiments, the photocleavable group,
R², is selected from the group consisting of -

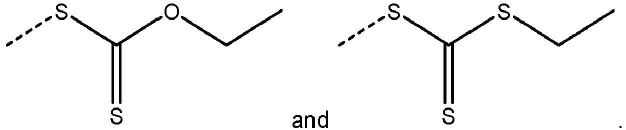

The comonomers that include the photocleavable group, R², may be formed by any known technique. In some embodiments, the comonomers are produced according to the reactions depicted in the following scheme, which can be modified to produce each of the embodiments described herein:

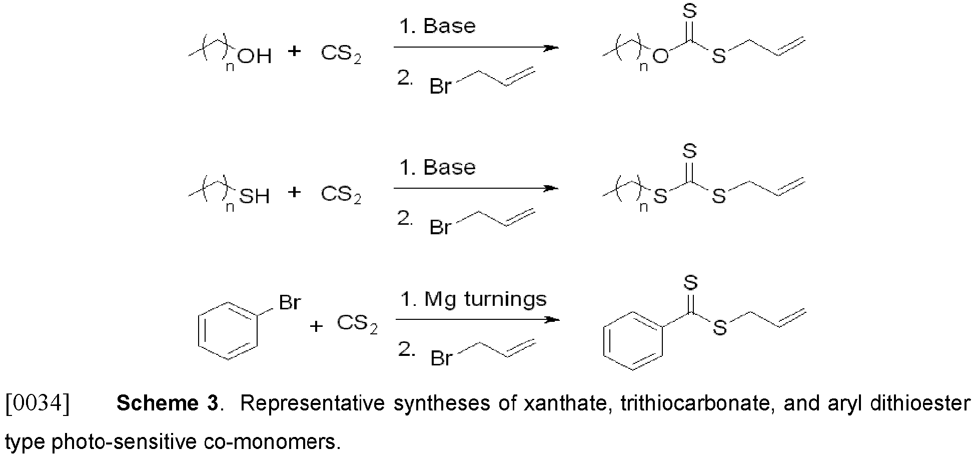

In some embodiments, the light responsive photoresist includes a polymer of formula (Ia): 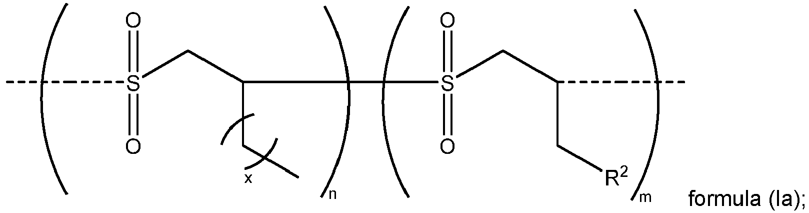 wherein x is 1 to 9; wherein n is 1 to 10,000; wherein m is 1 to 10,000; and wherein R² is a photocleavable group. In some embodiments, R² of formula (Ia) is a photocleavable group of formula (II) - 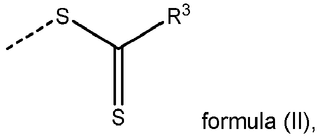 wherein R³ is selected from the group consisting of - 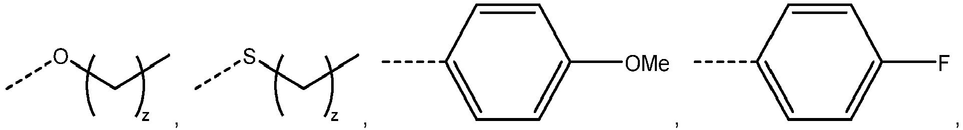 and 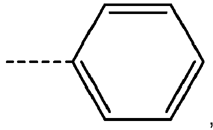 wherein z is 1 to 11. In some embodiments, the photocleavable group of formula (Ia) is selected from the group consisting of-

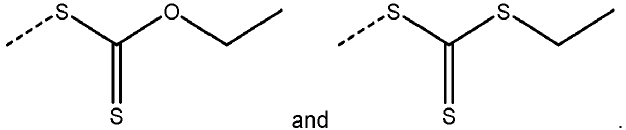

In some embodiments, the light responsive photoresist includes a polymer of formula (Ib): 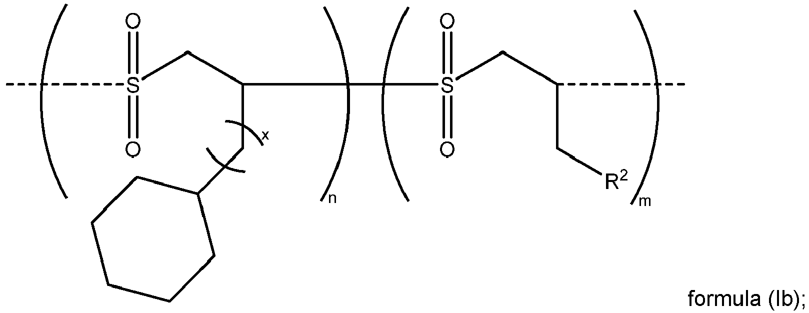 wherein x is 1 to 4. wherein n is 1 to 10,000; wherein m is 1 to 10,000; and wherein R² is a photocleavable group. In some embodiments, R² of formula (lb) is a photocleavable group of formula (II) - 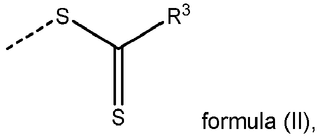 wherein R³ is selected from the group consisting of - 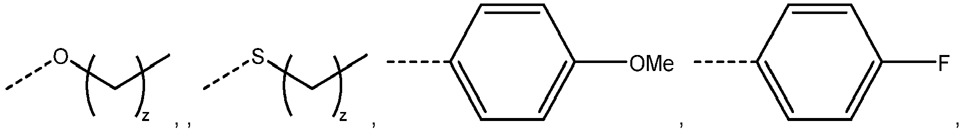 and 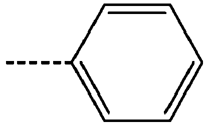 , wherein z is 1 to 11. In some embodiments, the photocleavable group of formula (Ib) is selected from the group consisting of -

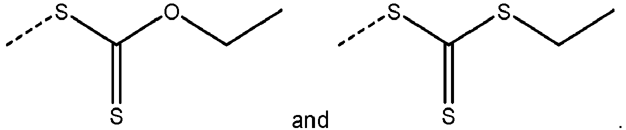

The light responsive photoresists having structures according to formula (I), formula (Ia), or formula (Ib) may include any ratio of "n" to "m". In some embodiments, the ratio of "n" to "m" is about 99:1 to about 50:50, about 99:1 to about 60:40, about 99:1 to about 70:30, about 99:1 to about 80:20, about 99:1 to about 90:10, about 90:10 to about 50:50, about 80:20 to about 50:50, about 70:30 to about 50:50, or about 60:40 to about 50:50.

The phrases "C₁-C₁₀ hydrocarbyl", and the like, as used herein, generally refer to unsubstituted or substituted aliphatic, unsubstituted or substituted aryl, or unsubstituted or substituted arylalkyl groups containing 1 to 10 carbon atoms. Examples of aliphatic groups, in each instance, include, but are not limited to, an alkyl group, a cycloalkyl group, an alkenyl group, a cycloalkenyl group, an alkynyl group, an alkadienyl group, a cyclic group, and the like, and includes all substituted, unsubstituted, branched, and linear analogs or derivatives thereof, in each instance having 1 to about 10 carbon atoms. Examples of alkyl groups include, but are not limited to, methyl, ethyl, propyl, isopropyl, n-butyl, t-butyl, isobutyl, pentyl, hexyl, isohexyl, heptyl, 4,4-dimethylpentyl, octyl, 2,2,4-trimethylpentyl, nonyl, and decyl. Cycloalkyl moieties may be monocyclic or multicyclic, and examples include cyclopropyl, cyclobutyl, cyclopentyl, cyclohexyl, and adamantyl. Additional examples of alkyl moieties have linear, branched and/or cyclic portions (e.g., 1-ethyl-4-methyl-cyclohexyl). Representative alkenyl moieties include vinyl, allyl, 1-butenyl, 2-butenyl, isobutylenyl, 1-pentenyl, 2-pentenyl, 3-methyl-1-butenyl, 2-methyl-2-butenyl, 2,3-dimethyl-2-butenyl, 1-hexenyl, 2-hexenyl, 3-hexenyl, 1-heptenyl, 2-heptenyl, 3-heptenyl, 1-octenyl, 2-octenyl, 3-octenyl, 1-nonenyl, 2-nonenyl, 3-nonenyl, 1-decenyl, 2-decenyl and 3-decenyl. Representative alkynyl moieties include acetylenyl, propynyl, 1-butynyl, 2-butynyl, 1-pentynyl, 2-pentynyl, 3-methyl-1-butynyl, 4-pentynyl, 1-hexynyl, 2-hexynyl, 5-hexynyl, 1-heptynyl, 2-heptynyl, 6-heptynyl, 1-octynyl, 2-octynyl, 7-octynyl, 1-nonynyl, 2-nonynyl, 8-nonynyl, 1-decynyl, 2-decynyl, and 9-decynyl. Examples of aryl or arylalkyl moieties include, but are not limited to, anthracenyl, azulenyl, biphenyl, fluorenyl, indan, indenyl, naphthyl, phenanthrenyl, phenyl, 1,2,3,4-tetrahydro-naphthalene, tolyl, xylyl, mesityl, benzyl, and the like, including any heteroatom substituted derivative thereof.

Unless otherwise indicated, the term "substituted", when used to describe a chemical structure or moiety, refers to a derivative of that structure or moiety wherein (i) a multi-valent non-carbon atom (e.g., oxygen, nitrogen, sulfur, phosphorus, etc.) is bonded to one or more carbon atoms of the chemical structure or moiety (e.g., a "substituted" C₄ hydrocarbyl may include, but is not limited to, diethyl ether moiety, a methyl propionate moiety, an N,N-dimethylacetamide moiety, a butoxy moiety, etc., and a "substituted" aryl C₁₂ hydrocarbyl may include, but is not limited to, an oxydibenzene moiety, a benzophenone moiety, etc.) or (ii) one or more of its hydrogen atoms (e.g., chlorobenzene may be characterized generally as an aryl C₆ hydrocarbyl "substituted" with a chlorine atom) is substituted with a chemical moiety or functional group such as alcohol, alkoxy, alkanoyloxy, alkoxycarbonyl, alkenyl, alkyl (e.g., methyl, ethyl, propyl, t-butyl), alkynyl, alkylcarbonyloxy (-OC(O)alkyl), amide (-C(O)NH-alkyl- or -alkylNHC(O)alkyl), tertiary amine (such as alkylamino, arylamino, arylalkylamino), aryl, aryloxy, azo, carbamoyl (-NHC(O)O-alkyl- or -OC(O)NH-alkyl), carbamyl (e.g., CONH₂, as well as CONH-alkyl, CONH-aryl, and CONH-arylalkyl), carboxyl, carboxylic acid, cyano, ester, ether (e.g., methoxy, ethoxy), halo, haloalkyl (e.g., -CCl₃, -CF₃, -C(CF₃)₃), heteroalkyl, isocyanate, isothiocyanate, nitrile, nitro, oxo, phosphodiester, sulfide, sulfonamido (e.g., SO₂NH₂), sulfone, sulfonyl (including alkylsulfonyl, arylsulfonyl and arylalkylsulfonyl), sulfoxide, thiol (e.g., sulfhydryl, thioether) or urea (-NHCONH-alkyl-).

All referenced publications are incorporated herein by reference in their entirety. Furthermore, where a definition or use of a term in a reference, which is incorporated by reference herein, is inconsistent or contrary to the definition of that term provided herein, the definition of that term provided herein applies and the definition of that term in the reference does not apply.

While certain aspects of conventional technologies have been discussed to facilitate disclosure of various embodiments, applicants in no way disclaim these technical aspects, and it is contemplated that the present disclosure may encompass one or more of the conventional technical aspects discussed herein.

The present disclosure may address one or more of the problems and deficiencies of known methods and processes. However, it is contemplated that various embodiments may prove useful in addressing other problems and deficiencies in a number of technical areas. Therefore, the present disclosure should not necessarily be construed as limited to addressing any of the particular problems or deficiencies discussed herein.

In this specification, where a document, act or item of knowledge is referred to or discussed, this reference or discussion is not an admission that the document, act or item of knowledge or any combination thereof was at the priority date, publicly available, known to the public, part of common general knowledge, or otherwise constitutes prior art under the applicable statutory provisions; or is known to be relevant to an attempt to solve any problem with which this specification is concerned.

In the descriptions provided herein, the terms "includes," "is," "containing," "having," and "comprises" are used in an open-ended fashion, and thus should be interpreted to mean "including, but not limited to." When devices, compositions, or methods are claimed or described in terms of "comprising" various steps or components, the devices, systems, or methods can also "consist essentially of" or "consist of" the various steps or components, unless stated otherwise.

The terms "a," "an," and "the" are intended to include plural alternatives, e.g., at least one. For instance, the disclosure of "a monomer", "a substrate", and the like, is meant to encompass one, or mixtures or combinations of more than one monomer, substrate, and the like, unless otherwise specified.

Various numerical ranges may be disclosed herein. When Applicant discloses or claims a range of any type, Applicant's intent is to disclose or claim individually each possible number that such a range could reasonably encompass, including end points of the range as well as any sub-ranges and combinations of sub-ranges encompassed therein, unless otherwise specified. Moreover, all numerical end points of ranges disclosed herein are approximate. As a representative example, Applicant discloses, in some embodiments, that the ratio of "n" to "m" is about 60:40 to about 50:50. This range should be interpreted as encompassing about 60:40 and about 50:50, and about 59:41, about 58:42, about 57:43, about 56:44, about 55:45, about 54:46, about 53:47, about 52:48, and about 51:49, including any ranges and sub-ranges between any of these values.

As used herein, the term "about" means plus or minus 10 % of the numerical value of the number with which it is being used.

Many modifications and other implementations of the disclosure set forth herein will be apparent having the benefit of the teachings presented in the foregoing descriptions and the associated drawings. Therefore, it is to be understood that the disclosure is not to be limited to the specific implementations disclosed and that modifications and other implementations are intended to be included within the scope of the appended claims. Although specific terms are employed herein, they are used in a generic and descriptive sense only and not for purposes of limitation.

The following examples pertain to further embodiments.

Example 1 may include a method, comprising: providing a substrate having a surface at least partially coated with a light responsive photoresist; cleaving at least a portion of the light responsive photoresist to form a cleaved photoresist by (i) irradiating the at least a portion of the light responsive photoresist with light of one or more wavelengths effective to cleave the light responsive photoresist, (ii) heating the at least a portion of the light responsive photoresist at a temperature and for a time effective to cleave the light responsive photoresist, or (iii) a combination thereof; and removing the cleaved photoresist from the substrate.

Example 2 may include the method of example 1 and/or any other example herein, wherein the cleaving of the at least a portion of the light responsive photoresist and the removing of the cleaved photoresist occur simultaneously.

Example 3 may include the method of example 1 and/or any other example herein, wherein the removing of the cleaved photoresist comprises applying vacuum, heat, or a combination thereof.

Example 4 may include the method of example 1 and/or any other example herein, wherein the cleaved photoresist is a gas.

Example 5 may include the method of example 1 and/or any other example herein, wherein the light responsive photoresist comprises a polymer, the polymer comprising a plurality of side chains, wherein one or more of the sidechains comprises a photocleavable group.

Example 6 may include the method of example 5 and/or any other example herein, wherein the cleaving of the at least a portion of the light responsive photoresist depolymerizes the polymer.

Example 7 may include the method of example 5 and/or any other example herein, wherein the light responsive photoresist comprises a poly(olefin sulfone) comprising one or more photocleavable groups.

Example 8 may include the method of example 7 and/or any other example herein, wherein the photoresist comprises a polymer of the following formula: 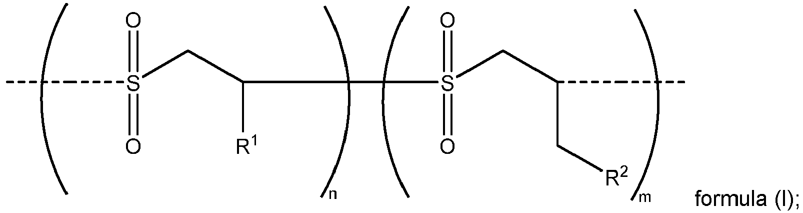
wherein n is 1 to 10,000;
wherein m is 1 to 10,000;
wherein R1 is a C1-C10 hydrocarbyl;
wherein R2 is a photocleavable group of formula (II) - 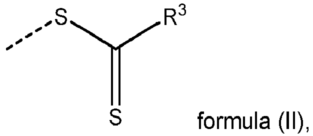
wherein R3 is selected from the group consisting of - 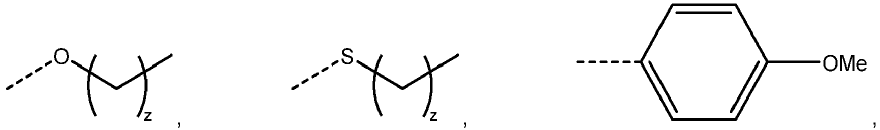 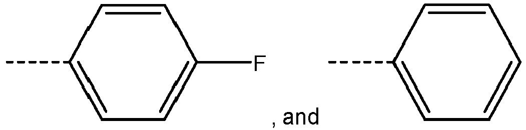 ; and
wherein z is 1 to 11.

Example 9 may include the method of example 8 and/or any other example herein, wherein the photoresist comprises a polymer of the following formula: 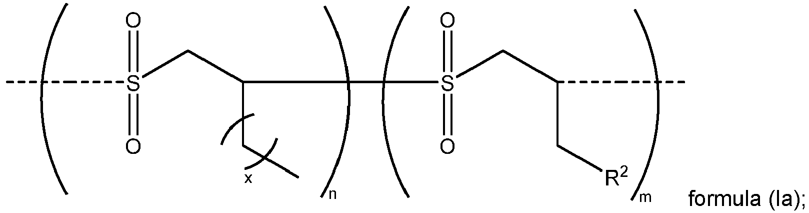 wherein x is 1 to 9.

Example 10 may include the method of example 8 and/or any other example herein, wherein the photoresist comprises a polymer of the following formula: 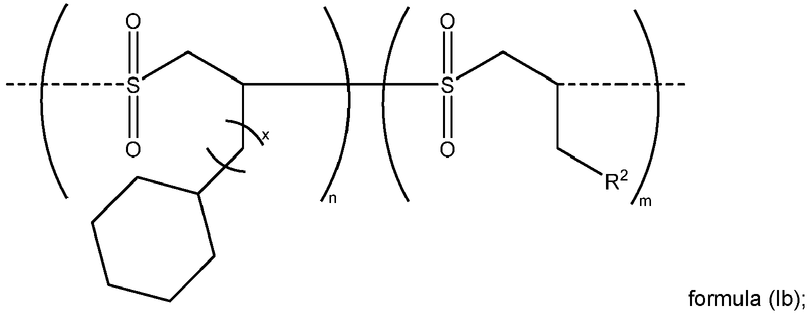 wherein x is 1 to 4.

Example 11 may include the method of example 1 and/or any other example herein, wherein the light of one or more wavelengths consists of light of one wavelength.

Example 12 may include the method of example 1 and/or any other example herein, wherein the light of one or more wavelengths consists of light of two or more wavelengths within a range of about 10 nm.

Example 13 may include a method, comprising: providing a substrate having a surface at least partially coated with a light responsive photoresist; cleaving a first portion of the light responsive photoresist by irradiating the first portion of the light responsive photoresist with light of one or more wavelengths effective to cleave the first portion of the light responsive photoresist; removing the first portion of the light responsive photoresist by vacuum, wherein the cleaving of the first portion of the light responsive photoresist and the removing of the first portion of the light responsive photoresist occur simultaneously; optionally subjecting the substrate to desmearing; plating the substrate with one or more materials; cleaving the second portion of the light responsive photoresist by (i) heating the second portion of the light responsive photoresist at a temperature and for a time effective to cleave the second portion of the light responsive photoresist, (ii) irradiating the second portion of the light responsive photoresist with light of one or more wavelengths effective to cleave the second portion light responsive photoresist, or (iii) a combination thereof; and removing the second portion of the light responsive photoresist.

Example 14 may include the method of example 13 and/or any other example herein, wherein the cleaving and the removing of the second portion of the light responsive photoresist occur simultaneously.

Example 15 may include the method of example 13 and/or any other example herein, wherein the light responsive photoresist comprises a polymer, the polymer comprising a plurality of side chains, wherein one or more of the side chains comprises a photocleavable group.

Example 16 may include the method of example 13 and/or any other example herein, wherein the light responsive photoresist comprises a poly(olefin sulfone) comprises one or more photocleavable groups.

Example 17 may include the method of example 16 and/or any other example herein, wherein the photoresist comprises a polymer of the following formula: 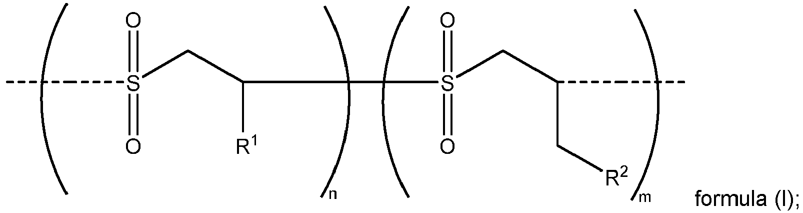
wherein n is 1 to 10,000;
wherein m is 1 to 10,000;
wherein R1 is a C1-C10 hydrocarbyl;
wherein R2 is a photocleavable group of formula (II) - 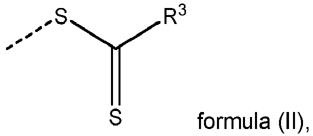
wherein R3 is selected from the group consisting of - 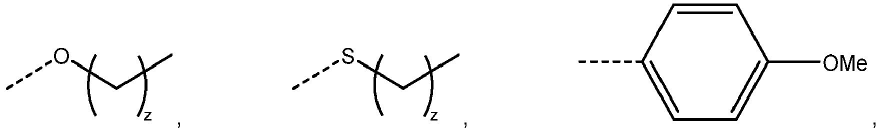 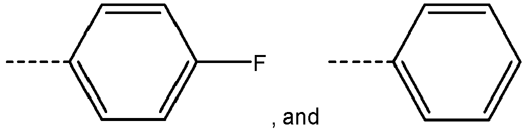 ; and
wherein z is 1 to 11.

Example 18 may include the method of example 17 and/or any other example herein, wherein the photoresist comprises a polymer of the following formula: 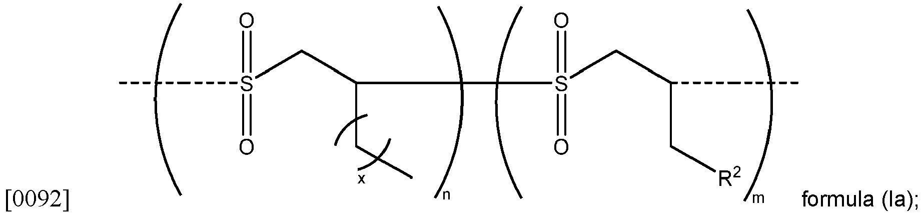 wherein x is 1 to 9.

Example 19 may include the method of example 17 and/or any other example herein, wherein the photoresist comprises a polymer of the following formula: 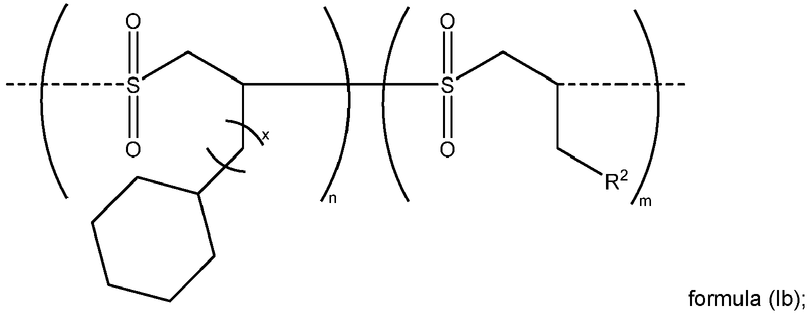 wherein x is 1 to 4.

Example 20 may include the method of example 13 and/or any other example herein, wherein the light of one or more wavelengths (i) consists of light of one wavelength, or (ii) consists of light of one or more wavelengths within a range of about 10 nm.

Certain aspects of the disclosure are described above with reference to block and flow diagrams of systems, methods, apparatuses, and/or computer program products according to various implementations. It will be understood that one or more blocks of the block diagrams and flow diagrams, and combinations of blocks in the block diagrams and the flow diagrams, respectively, may be implemented by computer-executable program instructions. Likewise, some blocks of the block diagrams and flow diagrams may not necessarily need to be performed in the order presented, or may not necessarily need to be performed at all, according to some implementations.

Accordingly, blocks of the block diagrams and flow diagrams support combinations of means for performing the specified functions, combinations of elements or steps for performing the specified functions and program instruction means for performing the specified functions. It will also be understood that each block of the block diagrams and flow diagrams, and combinations of blocks in the block diagrams and flow diagrams, may be implemented by special-purpose, hardware-based computer systems that perform the specified functions, elements or steps, or combinations of special-purpose hardware and computer instructions.

Conditional language, such as, among others, "can," "could," "might," or "may," unless specifically stated otherwise, or otherwise understood within the context as used, is generally intended to convey that certain implementations could include, while other implementations do not include, certain features, elements, and/or operations. Thus, such conditional language is not generally intended to imply that features, elements, and/or operations are in any way required for one or more implementations or that one or more implementations necessarily include logic for deciding, with or without user input or prompting, whether these features, elements, and/or operations are included or are to be performed in any particular implementation.

Many modifications and other implementations of the disclosure set forth herein will be apparent having the benefit of the teachings presented in the foregoing descriptions and the associated drawings. Therefore, it is to be understood that the disclosure is not to be limited to the specific implementations disclosed and that modifications and other implementations are intended to be included within the scope of the appended claims. Although specific terms are employed herein, they are used in a generic and descriptive sense only and not for purposes of limitation.

## Claims

1. A method, comprising:
providing a substrate having a surface at least partially coated with a light responsive photoresist;
cleaving at least a portion of the light responsive photoresist to form a cleaved photoresist by (i) irradiating the at least a portion of the light responsive photoresist with light of one or more wavelengths effective to cleave the light responsive photoresist, (ii) heating the at least a portion of the light responsive photoresist at a temperature and for a time effective to cleave the light responsive photoresist, or (iii) a combination thereof; and
removing the cleaved photoresist from the substrate.

2. The method of claim 1, wherein the cleaving of the at least a portion of the light responsive photoresist and the removing of the cleaved photoresist occur simultaneously.

3. The method of claim 1, wherein the removing of the cleaved photoresist comprises applying vacuum, heat, or a combination thereof.

4. The method of claim 1, wherein the cleaved photoresist is a gas.

5. The method of claim 1, wherein the light responsive photoresist comprises a poly(olefin sulfone) comprising one or more photocleavable groups.

6. The method of claim 5, wherein the photoresist comprises a polymer of the following formula: 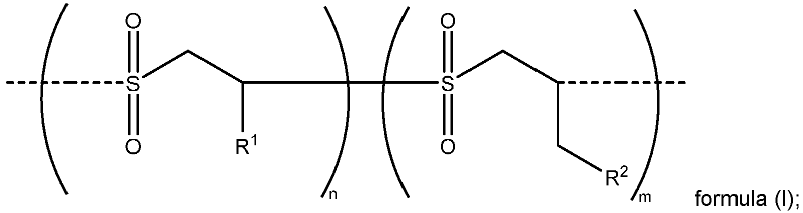
wherein n is 1 to 10,000;
wherein m is 1 to 10,000;
wherein R¹ is a C₁-C₁₀ hydrocarbyl;
wherein R² is a photocleavable group of formula (II) - 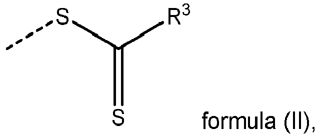 wherein R³ is selected from the group consisting of - 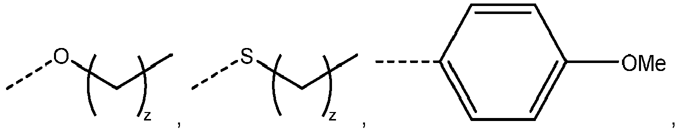 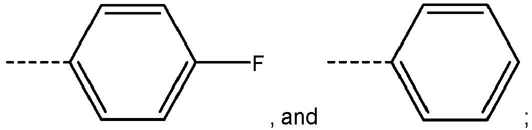 and
wherein z is 1 to 11.

7. The method of claim 6, wherein the photoresist comprises a polymer of the following formula: 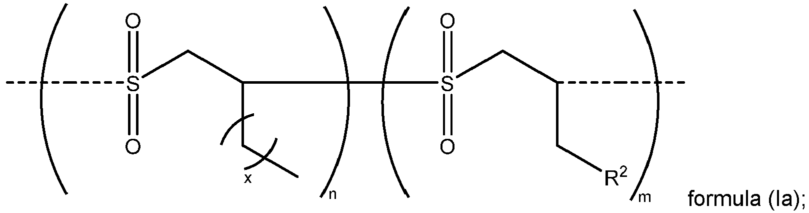 wherein x is 1 to 9.

8. The method of claim 6, wherein the photoresist comprises a polymer of the following formula: 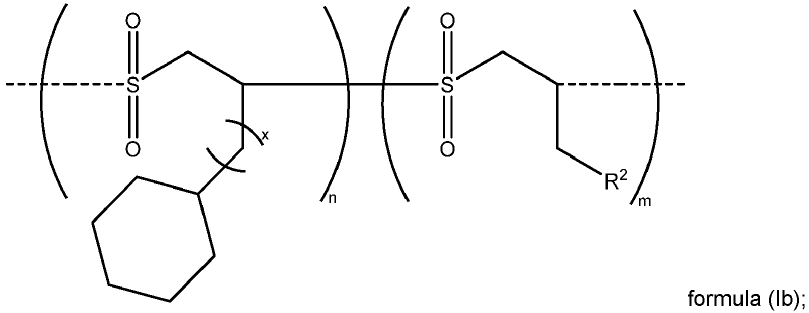 wherein x is 1 to 4.

9. The method of claim 1, wherein the light of one or more wavelengths consists of light of one wavelength.

10. The method of any one of claims 1-9, wherein the light of one or more wavelengths consists of light of two or more wavelengths within a range of about 10 nm.

11. A method, comprising:
providing a substrate having a surface at least partially coated with a light responsive photoresist;
cleaving a first portion of the light responsive photoresist by irradiating the first portion of the light responsive photoresist with light of one or more wavelengths effective to cleave the first portion of the light responsive photoresist;
removing the first portion of the light responsive photoresist by vacuum, wherein the cleaving of the first portion of the light responsive photoresist and the removing of the first portion of the light responsive photoresist occur simultaneously;
optionally subjecting the substrate to desmearing;
plating the substrate with one or more materials;
cleaving the second portion of the light responsive photoresist by (i) heating the second portion of the light responsive photoresist at a temperature and for a time effective to cleave the second portion of the light responsive photoresist, (ii) irradiating the second portion of the light responsive photoresist with light of one or more wavelengths effective to cleave the second portion light responsive photoresist, or (iii) a combination thereof; and
removing the second portion of the light responsive photoresist.

12. The method of claim 11, wherein the light responsive photoresist comprises a poly(olefin sulfone) comprises one or more photocleavable groups.

13. The method of claim 12, wherein the photoresist comprises a polymer of the following formula: 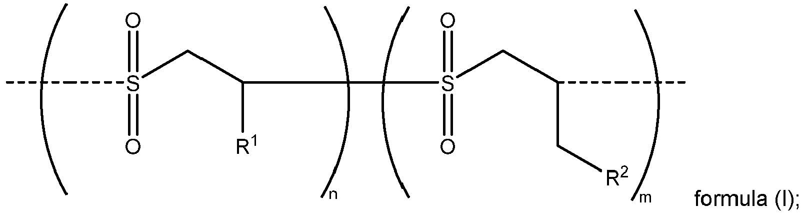
wherein n is 1 to 10,000;
wherein m is 1 to 10,000;
wherein R¹ is a C₁-C₁₀ hydrocarbyl;
wherein R² is a photocleavable group of formula (II) - 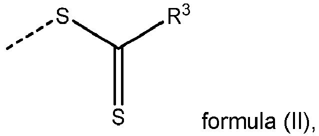 wherein R³ is selected from the group consisting of - 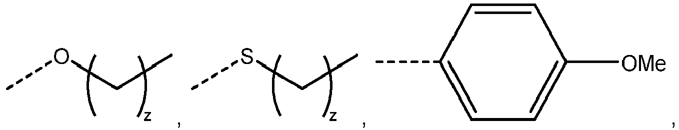 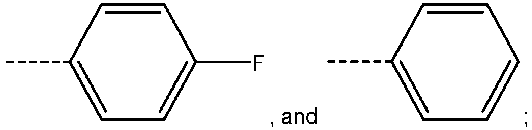 and
wherein z is 1 to 11.

14. The method of claim 13, wherein the photoresist comprises a polymer of the following formula: 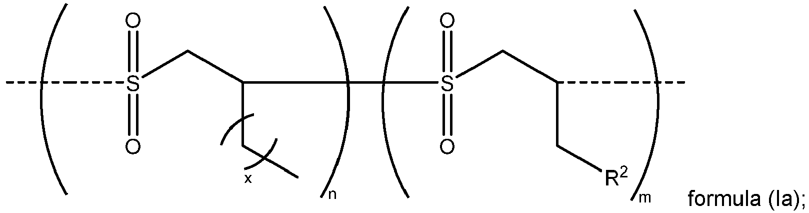 wherein x is 1 to 9.

15. The method of any one of claims 13-14, wherein the photoresist comprises a polymer of the following formula: 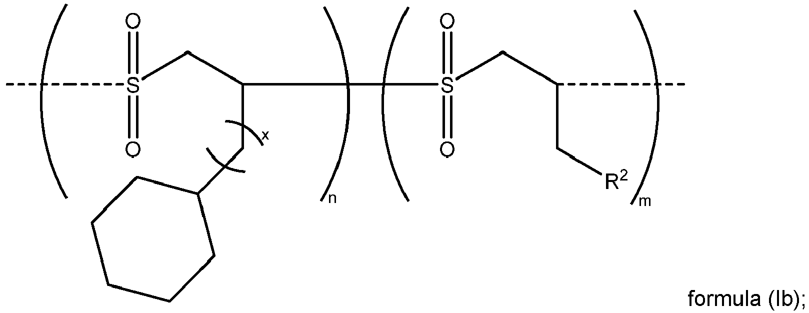 wherein x is 1 to 4.
